# EUROPEAN PATENT APPLICATION

(11) **EP 3 605 593 A1**
(43) Date of publication of application: **05.02.2020**
(21) Application number: 18774862.9
(22) Date of filing: 27.03.2018
(51) Int. Cl.: H01L 21/338, H01L 21/337, H01L 29/778, H01L 29/808, H01L 29/812

(54) **SEMICONDUCTOR DEVICE**

(30) Priority: 31.03.2017 JP 2017072704
(71) Applicant: Panasonic Intellectual Property Management Co., Ltd., Osaka-shi, Osaka 540-6207 (JP)
(72) Inventor: SUZUKI, Asamira, Osaka-shi, Osaka 540-6207 (JP); UENO, Hiroaki, Osaka-shi, Osaka 540-6207 (JP); ISHIDA, Hidetoshi, Osaka-shi, Osaka 540-6207 (JP)
(74) Representative: Vigand, Philippe
(86) International application number: PCT/JP2018/012280
(87) International publication number: WO 2018/181237

(57) **Abstract**

An object of the present invention is to provide a semiconductor device with the ability to reduce its resistance. A semiconductor device (1) includes a substrate (2), a semiconductor portion (3), a first electrode (4), and a second electrode (5). The substrate (2) has a first surface (21) and a second surface (22) which are located opposite from each other in a thickness direction (D3) defined for the substrate (2). The semiconductor portion (3) is provided on the first surface (21) of the substrate (2). The semiconductor portion (3) includes a heterojunction (35) defining a junction between a first compound semiconductor portion (31) and a second compound semiconductor portion (32) and intersecting with a first direction (D1) defined along the first surface (21) of the substrate (2). The first electrode (4) and the second electrode (5) are arranged on a first end surface (301) of the semiconductor portion (3) and on a second end surface (302) of the semiconductor portion (3), respectively, in a second direction (D2) defined along the first surface (21) of the substrate (2) and aligned with a direction in which the heterojunction (35) extends. The first electrode (4) and the second electrode (5) are electrically connected to the heterojunction (35).

## Description

### Technical Field

The present invention generally relates to a semiconductor device, and more particularly relates to a semiconductor device with a heterojunction.

### Background Art

A nitride semiconductor device, such as a field effect transistor, which uses a GaN-based compound semiconductor material, has been known as an exemplary semiconductor device (see, for example, Patent Literature 1).

The nitride semiconductor device described in Patent Literature 1 includes: a substrate of sapphire, of which the principal surface has a (0001) plane; a first semiconductor layer of undoped GaN; a second semiconductor layer formed on the first semiconductor layer and made of undoped Al_{0.15}Ga_{0.85}N; a control region formed locally on the second semiconductor layer; a gate electrode formed on the control region; and a source electrode and a drain electrode formed on the second semiconductor layer. The control region is made up of a control layer and a contact layer. The control layer is made of p-type Al_{0.15}Ga_{0.85}N formed on the second semiconductor layer. The contact layer is made of high-concentration p-type GaN formed on the control layer.

A semiconductor device such as a transistor or a diode suitably causes as little loss as possible in on state.

### Citation List

### Patent Literature

Patent Literature 1: JP 2007-201093 A

### Summary of Invention

It is an object of the present invention to provide a semiconductor device with the ability to reduce its resistance.

### Solution to Problem

A semiconductor device according to an aspect of the present invention includes a substrate, a semiconductor portion, a first electrode, and a second electrode. The substrate has a first surface and a second surface that are located opposite from each other in a thickness direction defined for the substrate. The semiconductor portion is provided on the first surface of the substrate. The semiconductor portion includes a heterojunction defining a junction between a first compound semiconductor portion and a second compound semiconductor portion and intersecting with a first direction defined along the first surface of the substrate. The first electrode and the second electrode are arranged on a first end surface of the semiconductor portion and on a second end surface of the semiconductor portion, respectively, in a second direction defined along the first surface of the substrate and aligned with a direction in which the heterojunction extends. The first electrode and the second electrode are electrically connected to the heterojunction.

In this semiconductor device, the substrate is suitably a nitride semiconductor substrate. The first surface of the substrate is suitably a crystallographic plane extending along a c-axis. The first direction is suitably defined along the c-axis. Each of the first compound semiconductor portion and the second compound semiconductor portion is suitably a nitride semiconductor.

In this semiconductor device, the semiconductor portion suitably includes a plurality of the heterojunctions.

In this semiconductor device, the plurality of the heterojunctions suitably extend parallel to each other.

In this semiconductor device, in the semiconductor portion, the second compound semiconductor portion has greater bandgap energy than the first compound semiconductor portion. The semiconductor device may further include a gate electrode which intersects with the first direction between the first electrode and the second electrode and which faces the heterojunction with at least the second compound semiconductor portion interposed between the gate electrode and the heterojunction.

This semiconductor device suitably further includes a gate layer interposed in the first direction between the gate electrode and the second compound semiconductor portion and forming a depletion layer in the second compound semiconductor portion and the first compound semiconductor portion.

In this semiconductor device, the semiconductor portion further includes a third compound semiconductor portion arranged, in the first direction, opposite from the second compound semiconductor portion with respect to the first compound semiconductor portion. In the semiconductor portion, bandgap energy of the second compound semiconductor portion and bandgap energy of the third compound semiconductor portion are each greater than bandgap energy of the first compound semiconductor portion. In this semiconductor device, the substrate is suitably a nitride semiconductor substrate, the first surface of the substrate is suitably a crystallographic plane extending along a c-axis, and each of the first compound semiconductor portion, the second compound semiconductor portion, and the third compound semiconductor portion is suitably a nitride semiconductor. The semiconductor portion suitably has a plurality of double heterostructures arranged to be spaced apart from each other in the first direction. In each of the plurality of double heterostructures, the third compound semiconductor portion, the first compound semiconductor portion, and the second compound semiconductor portion are arranged in this order in the first direction. Each of the plurality of double heterostructures has a first heterojunction defining the heterojunction between the first compound semiconductor portion and the second compound semiconductor portion and a second heterojunction defining a heterojunction between the first compound semiconductor portion and the third compound semiconductor portion. One of the first electrode or the second electrode may constitute an anode electrode, and the other may constitute a cathode electrode.

### Brief Description of Drawings

FIG. 1 is a perspective view of a semiconductor device according to an exemplary embodiment of the present invention;
FIG. 2 is a plan view of the semiconductor device;
FIG. 3 is a cross-sectional view, taken along a plane X1-X1 shown in FIG. 2, of the semiconductor device;
FIG. 4 is a cross-sectional view, taken along a plane X2-X2 shown in FIG. 2, of the semiconductor device;
FIG. 5 is a transversal cross-sectional view illustrating the semiconductor device;
FIGS. 6A-6C are cross-sectional views illustrating main process steps of a method for fabricating the semiconductor device;
FIGS. 7A-7C are cross-sectional views illustrating main process steps of the method for fabricating the semiconductor device;
FIGS. 8A-8C are cross-sectional views illustrating main process steps of the method for fabricating the semiconductor device;
FIG. 9 is a perspective view of a semiconductor device according to a first variation of the exemplary embodiment of the present invention; and
FIG. 10 is a perspective view of a semiconductor device according to a second variation of the exemplary embodiment of the present invention.

### Description of Embodiments

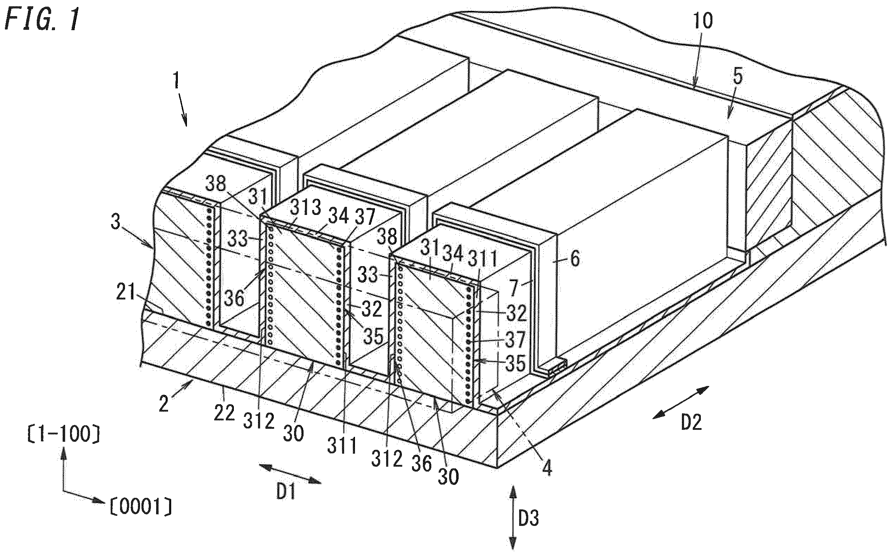

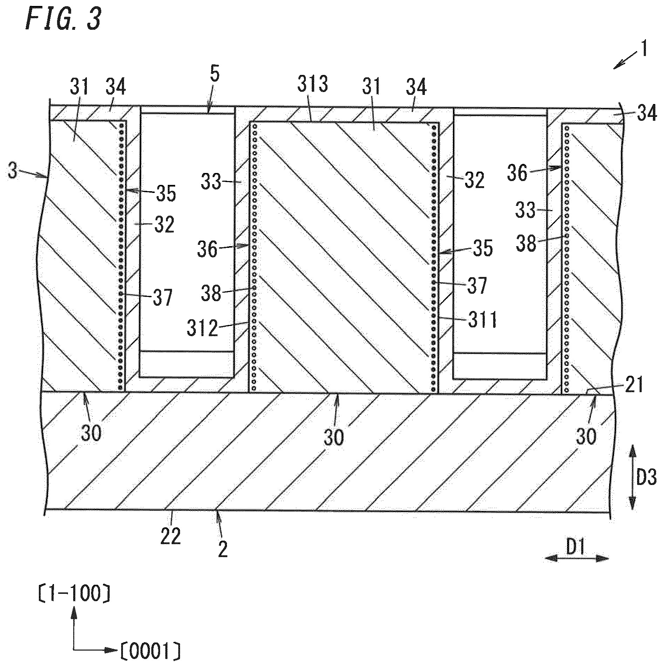

Note that FIGS. 1-10 to be referred to in the following description of the exemplary embodiment are just schematic representations, in which the dimensions and thicknesses of respective constituent elements and their ratios are not always to scale, compared with their actual dimensional ratios.

### (Embodiments)

A semiconductor device 1 according to an exemplary embodiment will be described with reference to FIGS. 1-5.

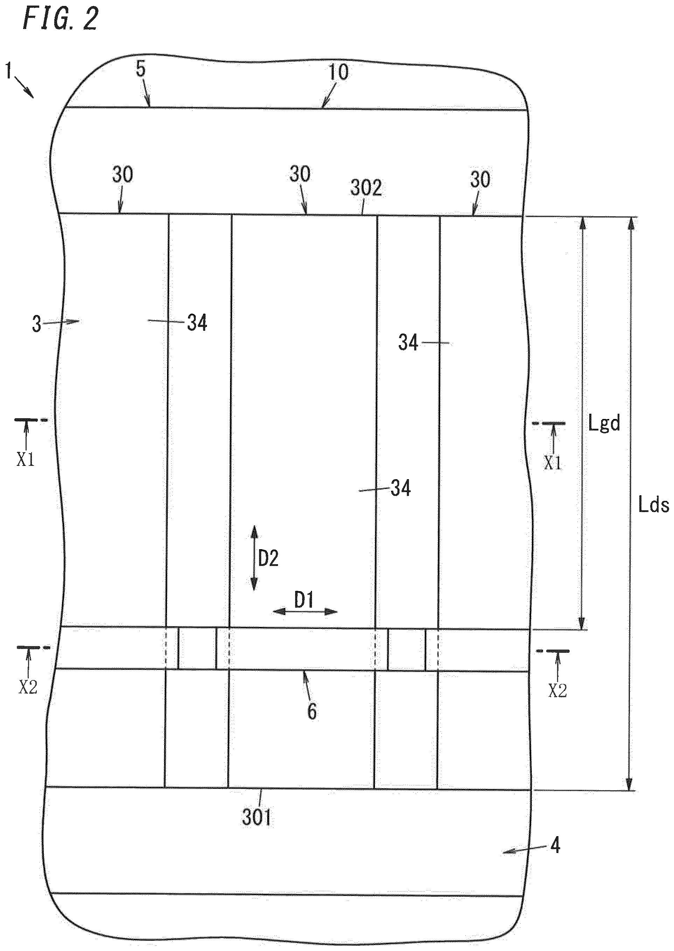

A semiconductor device 1 includes a substrate 2, a semiconductor portion 3, a first electrode 4, and a second electrode 5. The substrate 2 has a first surface 21 and a second surface 22 which are located opposite from each other in a thickness direction D3 defined for the substrate 2. The semiconductor portion 3 is provided on the first surface 21 of the substrate 2. The semiconductor portion 3 includes a heterojunction 35 defining a junction between a first compound semiconductor portion 31 and a second compound semiconductor portion 32 and intersecting with a first direction D1 defined along the first surface 21 of the substrate 2. The first electrode 4 and the second electrode 5 are arranged on a first end surface 301 of the semiconductor portion 3 (see FIG. 2) and on a second end surface 302 of the semiconductor portion 3 (see FIG. 2), respectively, in a second direction D2 defined along the first surface 21 of the substrate 2 and aligned with a direction in which the heterojunction 35 extends. The first electrode 4 and the second electrode 5 are electrically connected to the heterojunction 35.

This configuration allows the semiconductor device 1 to reduce the resistance between the first electrode 4 and the second electrode 5.

A semiconductor device 1 according to this embodiment is a field effect transistor chip, and further includes a third electrode 6 provided separately from the first electrode 4 and the second electrode 5. In the semiconductor device 1 according to this embodiment, the first electrode 4, the second electrode 5, and the third electrode 6 serve as a source electrode, a drain electrode, and a gate electrode, respectively. In the following description, the first electrode 4, the second electrode 5, and the third electrode 6 will be hereinafter referred to as a source electrode 4, a drain electrode 5, and a gate electrode 6, respectively, for the sake of convenience.

Next, respective constituent elements of the semiconductor device 1 will be described in further detail one by one.

The semiconductor device 1 may have a square planar shape, for example. As used herein, the "planar shape of the semiconductor device 1" refers to an outer peripheral shape of the semiconductor device 1 when viewed from either side of the substrate 2 in the thickness direction D3. When viewed in plan, the semiconductor device 1 may have a chip size of 1 mm square (1 mm × 1 mm). Note that this numerical value is only an example and should not be construed as limiting. In addition, the semiconductor device 1 does not have to have a square planar shape, either, but may also have a rectangular planar shape as well.

The substrate 2 supports the semiconductor portion 3 thereon. The substrate 2 may be a single crystal GaN substrate, for example. Therefore, the substrate 2 has a hexagonal crystal structure. The first direction D1 is defined along a c-axis of the substrate 2 (which may be parallel to the c-axis of the substrate 2, for example). The c-axis of the substrate 2 points rightward in FIG. 2. At the left corner of FIG. 1, shown are a crystallographic axis [0001] indicating the c-axis of the substrate 2 and a crystallographic axis [1-100] indicating the m-axis thereof. The single crystal GaN substrate may be a semi-insulating GaN substrate, for example. However, this is only an example and should not be construed as limiting. Alternatively, the single crystal GaN substrate may also be an n-type GaN substrate.

As described above, the substrate 2 has the first surface 21 and the second surface 22, which are located opposite from each other in the thickness direction D3 defined for the substrate 2. In this case, the first surface 21 of the substrate 2 is an m-plane, which may be a (1-100) plane, for example. As used herein, the negative sign "-" added to a Miller index representing a crystallographic plane orientation indicates the inversion of the index following the negative sign. The (1-100) plane is a crystallographic plane represented by four Miller indices enclosed in parentheses.

The first surface 21 of the substrate 2 may be a nonpolar plane defined by the c-axis and does not have to be an m-plane but may also be an a-plane as well. The a-plane may be a (1120) plane, for example. Alternatively, the first surface 21 of the substrate 2 may also be a crystallographic plane, of which an off-axis angle with respect to an m-plane (hereinafter referred to as a "first off-axis angle") is greater than 0 degrees and equal to or less than 5 degrees. As used herein, the "first off-axis angle" indicates a tilt angle of the first surface 21 with respect to the m-plane. Thus, if the first off-axis angle is 0 degrees, then the first surface 21 is an m-plane. Likewise, the first surface 21 of the substrate 2 may also be a crystallographic plane, of which an off-axis angle with respect to an a-plane (hereinafter referred to as a "second off-axis angle") is greater than 0 degrees and equal to or less than 5 degrees. As used herein, the "second off-axis angle" indicates a tilt angle of the first surface 21 with respect to the a-plane. Thus, if the second off-axis angle is 0 degrees, then the first surface 21 is an a-plane. The substrate 2 may have a thickness of 100 µm to 700 µm, for example.

The semiconductor portion 3 is provided on the first surface 21 of the substrate 2. The semiconductor portion 3 includes a first compound semiconductor portion 31 and a second compound semiconductor portion 32. In the semiconductor portion 3, the first compound semiconductor portion 31 and the second compound semiconductor portion 32 are arranged side by side in the first direction D1. The semiconductor portion 3 further includes a third compound semiconductor portion 33. The third compound semiconductor portion 33 is arranged, in the first direction D1, opposite from the second compound semiconductor portion 32 with respect to the first compound semiconductor portion 31. The semiconductor portion 3 further includes a fourth compound semiconductor portion 34. The fourth compound semiconductor portion 34 is located, in the thickness direction D3 defined for the substrate 2, opposite from the substrate 2 with respect to the first compound semiconductor portion 31.

In the semiconductor portion 3, the respective bandgap energies of the second compound semiconductor portion 32, the third compound semiconductor portion 33, and the fourth compound semiconductor portion 34 are greater than the bandgap energy of the first compound semiconductor portion 31. Also, in the semiconductor portion 3, when measured in the first direction D1, the thickness of each of the second compound semiconductor portion 32 and the third compound semiconductor portion 33 is less than that of the first compound semiconductor portion 31. Furthermore, in this semiconductor device 1, when measured in the thickness direction D3 defined for the substrate 2, the thickness of the fourth compound semiconductor portion 34 is less than that of the first compound semiconductor portion 31.

When measured in the thickness direction D3 defined for the substrate 2, the thickness of the first compound semiconductor portion 31 may be 10 µm, for example. Note that this numerical value is only an example and should not be construed as limiting. Alternatively, the first compound semiconductor portion 31 may also have a thickness falling within the range from about 5 µm to about 25 µm, for example. When measured in the first direction D1, the thickness of the first compound semiconductor portion 31 may be 8 µm, for example. When measured in the first direction D1, the respective thicknesses of the second compound semiconductor portion 32 and the third compound semiconductor portion 33 may each be 20 nm, for example. When measured in the thickness direction D3 defined for the substrate 2, the thickness of the fourth compound semiconductor portion 34 may be 20 nm, for example.

Each of the first compound semiconductor portion 31, the second compound semiconductor portion 32, the third compound semiconductor portion 33, and the fourth compound semiconductor portion 34 may be a Group III-V compound semiconductor (e.g., a nitride semiconductor in this example). More specifically, the first compound semiconductor portion 31 may be made up of undoped GaN crystals. Each of the second compound semiconductor portion 32, the third compound semiconductor portion 33, and the fourth compound semiconductor portion 34 may be made up of undoped AlGaN crystals. In the semiconductor portion 3, the second compound semiconductor portion 32, the third compound semiconductor portion 33, and the fourth compound semiconductor portion 34 have the same composition ratio. However, this is only an example and should not be construed as limiting. Alternatively, the second, third, and fourth compound semiconductor portions 32, 33, and 34 may have different composition ratios. In this specification, the composition ratio may be a value obtained by composition analysis according to energy dispersive X-ray spectroscopy (EDX). When their magnitudes are discussed, the composition ratios do not have to be values obtained by the EDX but may also be values obtained by composition analysis according to Auger electron spectroscopy, for example.

The semiconductor portion 3 has the heterojunction 35 defining a junction between the first compound semiconductor portion 31 and the second compound semiconductor portion 32 (hereinafter referred to as a "first heterojunction 35"). The first heterojunction 35 intersects (e.g., at right angles in this embodiment) with the first direction D1 defined along the first surface 21 of the substrate 2. The semiconductor portion 3 also has a heterojunction 36 defining a junction between the first compound semiconductor portion 31 and the third compound semiconductor portion 33 (hereinafter referred to as a "second heterojunction 36"). The second heterojunction 36 intersects (e.g., at right angles in this embodiment) with the first direction D1 defined along the first surface 21 of the substrate 2. However, the first heterojunction 35 and the second heterojunction 36 do not always intersect at right angles with the first direction D1 (i.e., the angle formed between each of the first heterojunction 35 and the second heterojunction 36 and the first direction D1 is not always 90 degrees). Alternatively, the angle formed between each of the first heterojunction 35 and the second heterojunction 36 and the first direction D1 may fall within the range from 80 degrees to 100 degrees, for example.

The first compound semiconductor portion 31 is formed directly on the first surface 21 of the substrate 2. The first compound semiconductor portion 31 has a first surface 311 and a second surface 312, which are located opposite from each other in the first direction D1, and a third surface 313, which is located, in the thickness direction D3 defined for the substrate 2, opposite from the substrate 2. The first surface 311 is a Group III polar plane (a Ga polar plane in this embodiment) of the first compound semiconductor portion 31. The Ga polar plane (+c plane) is a (0001) plane. The first surface 311 does not have to be a Group III polar plane but may also be a crystallographic plane forming a tilt angle of 1 to 10 degrees with respect to the Group III polar plane. The second surface 312 is a Group V polar plane (an N polar plane in this embodiment) of the first compound semiconductor portion 31. The N polar plane (-c plane) is a (000-1) plane. The second surface 312 does not have to be a Group V polar plane but may also be a crystallographic plane forming a tilt angle of 1 to 10 degrees with respect to the Group V polar plane. The third surface 313 is a nonpolar plane (e.g., an m-plane in this embodiment) of the first compound semiconductor portion 31. The third surface 313 does not have to be an m-plane but may also be an a-plane as well, for example. Alternatively, the third surface 313 may also be a crystallographic plane forming an off-axis angle (hereinafter referred to as a "third off-axis angle") greater than 0 degrees and equal to or less than 5 degrees with respect to the m-plane. Still alternatively, the third surface 313 may also be a crystallographic plane forming an off-axis angle (hereinafter referred to as a "fourth off-axis angle") greater than 0 degrees and equal to or less than 5 degrees with respect to the a-plane.

In the semiconductor portion 3, the first heterojunction 35 is formed to include the first surface 311 of the first compound semiconductor portion 31. In addition, in the semiconductor portion 3, the second heterojunction 36 is formed to include the second surface 312 of the first compound semiconductor portion 31.

In the semiconductor portion 3, in the vicinity of the first heterojunction 35 intersecting with the first direction D1, a two-dimensional electron gas 37 has been generated by spontaneous polarization and piezoelectric polarization of a nitride semiconductor (e.g., undoped AlGaN crystals that form the second compound semiconductor portion 32). In other words, in the semiconductor portion 3, the heterojunction 35 between the first compound semiconductor portion 31 and the second compound semiconductor portion 32 generates the two-dimensional electron gas 37. A region including the two-dimensional electron gas 37 (hereinafter referred to as a "two-dimensional electron gas layer") may function as an n-channel layer (electron conduction layer). In addition, in the semiconductor portion 3, in the vicinity of the second heterojunction 36 intersecting with the first direction D1, a two-dimensional hole gas 38 has been generated by spontaneous polarization and piezoelectric polarization of undoped AlGaN crystals that form the third compound semiconductor portion 33. A region including the two-dimensional hole gas 38 (hereinafter referred to as a "two-dimensional hole gas layer") may function as a p-channel layer (hole conduction layer). Each of the two-dimensional electron gas 37 and the two-dimensional hole gas 38 is electrically insulated from the substrate 2.

The semiconductor portion 3 suitably includes a plurality of (e.g., 1,000) double heterostructures 30, which are arranged side by side in the first direction D1 so as to be separated from each other. In each of the double heterostructures 30, the third compound semiconductor portion 33, the first compound semiconductor portion 31, and the second compound semiconductor portion 32 are arranged in this order in the first direction D1. In the semiconductor portion 3, each of the plurality of double heterostructures 30 includes the fourth compound semiconductor portion 34. The semiconductor portion 3 includes a plurality of first compound semiconductor portions 31, a plurality of second compound semiconductor portions 32, a plurality of third compound semiconductor portions 33, and a plurality of fourth compound semiconductor portions 34.

Each of the double heterostructures 30 has the first heterojunction 35 and the second heterojunction 36. Thus, the semiconductor portion 3 includes a plurality of (e.g., 1,000) first heterojunctions 35 and a plurality of (e.g., 1,000) second heterojunctions 36. In this embodiment, in the semiconductor portion 3, the plurality of first heterojunctions 35 extend parallel to each other, and the plurality of second heterojunctions 36 also extend parallel to each other. In this semiconductor device 1, the plurality of first heterojunctions 35 are arranged in the first direction D1 at generally regular intervals. Also, in this semiconductor device 1, the interval between two first heterojunctions 35 adjacent to each other in the first direction D1 may be 10 µm, for example. Furthermore, in this semiconductor device 1, the interval between two second heterojunctions 36 adjacent to each other in the first direction D1 may also be 10 µm, for example.

The semiconductor portion 3 may be formed by, for example, epitaxial growth, photolithography, and etching techniques.

The first compound semiconductor portion 31 may be formed by epitaxial growth, for example. In that case, the epitaxial growth may be a metalorganic vapor phase epitaxy (MOVPE), for example. However, this is only an example and should not be construed as limiting. The epitaxial growth does not have to be the MOVPE but may also be hydride vapor phase epitaxy (HVPE) or molecular beam epitaxy (MBE), for example. The second compound semiconductor portion 32, the third compound semiconductor portion 33, and the fourth compound semiconductor portion 34 may also be formed by epitaxial growth, for example. In that case, the epitaxial growth is suitably the MOVPE. The undoped GaN crystals and the undoped AlGaN crystals may include Mg, H, Si, C, O, and other impurities to be inevitably contained during their growth.

The semiconductor device 1 includes the first electrode 4 (source electrode 4), the second electrode 5 (drain electrode 5), and the third electrode 6 (gate electrode 6) as described above.

The source electrode 4 and the drain electrode 5 are arranged on a first end surface 301 of the semiconductor portion 3 and on a second end surface 302 of the semiconductor portion 3, respectively, in the second direction D2 defined along the first surface 21 of the substrate 2 and aligned with the direction in which the first heterojunction 35 extends. The first electrode 4 and the second electrode 5 are electrically connected to the first heterojunction 35. More specifically, the first electrode 4 and the second electrode 5 are electrically connected to the plurality of first heterojunctions 35. In addition, the first electrode 4 and the second electrode 5 are electrically connected to the plurality of second heterojunctions 36. Each of the first electrode 4 and the second electrode 5 is formed to make an ohmic contact with the plurality of first heterojunctions 35 and the plurality of second heterojunctions 36.

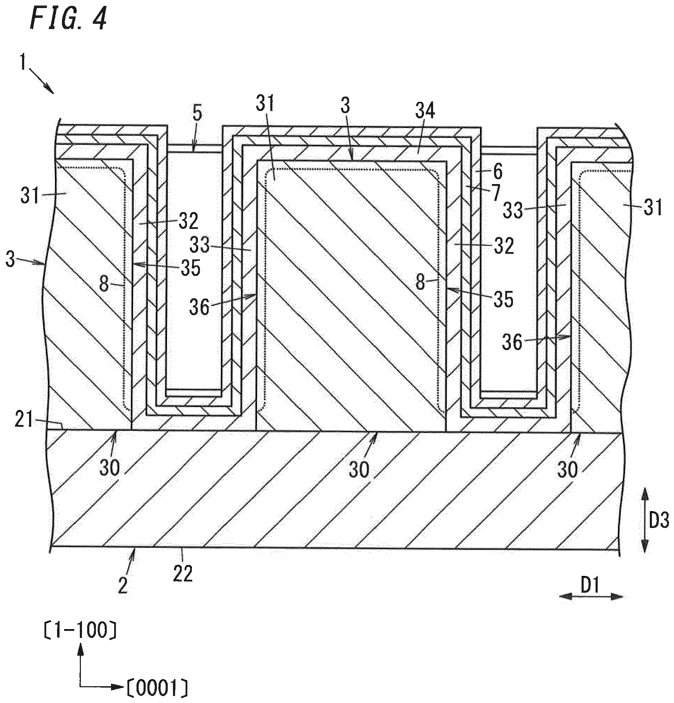

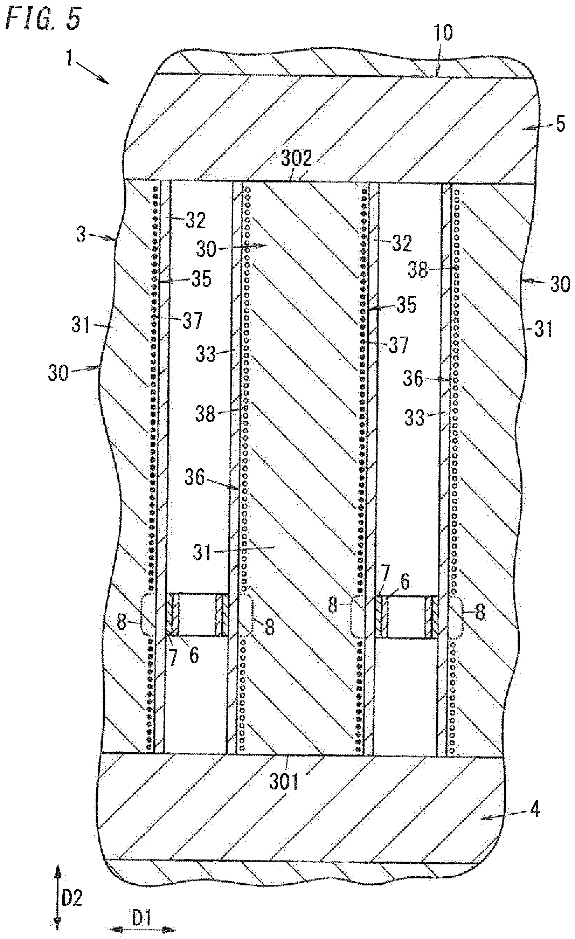

A gate layer 7 is formed to provide a normally off-mode field effect transistor by creating a depletion layer 8 (see FIGS. 4 and 5) in the semiconductor portion 3. The gate layer 7 is spaced in the second direction D2 from both of the first electrode 4 and the second electrode 5. The gate layer 7 is located in the first direction D1 between the gate electrode 6 and the double heterostructure 30. The gate layer 7 forms the depletion layer 8 in the semiconductor portion 3 when no voltage is applied between the gate electrode 6 and the source electrode 4 or between the drain electrode 5 and the source electrode 4.

In the semiconductor device 1 according to this embodiment, the distance in the second direction D2 from the gate layer 7 to the source electrode 4 is shorter than the distance in the second direction D2 from the gate layer 7 to the drain electrode 5. When taken along a plane perpendicular to the second direction D2, the gate layer 7 is formed along the surface of the semiconductor portion 3. That is to say, the gate layer 7 is formed to cover the plurality of double heterostructures 30. In this embodiment, the gate layer 7 has a meandering shape in a plane perpendicular to the second direction D2. The gate layer 7 may be a p-type metal oxide semiconductor layer, for example. In this embodiment, the p-type metal oxide semiconductor layer may be an NiO layer, for example. Optionally, the NiO layer may contain, as an impurity, at least one alkali metal selected from the group consisting of lithium (Li), sodium (Na), potassium (K), rubidium (Rb), and cesium (Cs). The NiO layer may also contain a transition metal such as silver (Ag) or copper (Cu) which becomes univalent when added as an impurity. When measured in the first direction D1, the thickness of the gate layer 7 may be 100 nm, for example.

The gate electrode 6 is formed on the gate layer 7. In short, the gate electrode 6 is formed along the surface of the gate layer 7. When taken along a plane perpendicular to the second direction D2, the gate electrode 6 is formed along the surface of the semiconductor portion 3 with the gate layer 7 interposed. The gate electrode 6 is formed to cover the plurality of double heterostructures 30 with the gate layer 7 interposed. In this embodiment, when taken along a plane perpendicular to the second direction D2, the gate electrode 6 has a meandering shape.

In this semiconductor device 1, part of the semiconductor portion 3 is present, in the thickness direction D3 defined for the substrate 2, between the source electrode 4, the drain electrode 5, and the gate electrode 6 and the substrate 2. However, since the substrate 2 is a semi-insulating GaN substrate, at least respective parts of the first electrode 4, second electrode 5, and third electrode 6 may be formed directly on the substrate 2, for example. Nevertheless, if the substrate 2 is an n-type GaN substrate, part of the semiconductor portion 3 is suitably present, in the thickness direction D3 defined for the substrate 2, between the source electrode 4, the drain electrode 5, and the gate electrode 6 and the substrate 2 to electrically insulate and isolate the source electrode 4, the drain electrode 5, and the gate electrode 6 from each other.

A field effect transistor chip constituting the semiconductor device 1 includes a field effect transistor section 10 and the substrate 2. In this case, the field effect transistor section 10 includes the semiconductor portion 3, the source electrode 4, the drain electrode 5, the gate electrode 6, and the gate layer 7.

In the semiconductor device 1, the breakdown voltage of the semiconductor device 1 may be determined by a gate-drain distance Lgd (see FIG. 2), which is the distance between the gate electrode 6 and the drain electrode 5. Also, in this semiconductor device 1, the resistance (on-state resistance) of the semiconductor device 1 may be determined by a drain-source distance Lds, which is the distance between the drain electrode 5 and the source electrode 4. The on-state resistance depends on not only the drain-source distance Lds but also the length of the first heterojunction 35 as measured in the thickness direction D3 defined for the substrate 2 and other parameters as well.

As can be seen from the foregoing description, the semiconductor device 1 according to this embodiment includes a substrate 2, a semiconductor portion 3, a first electrode 4, and a second electrode 5. The substrate 2 has a first surface 21 and a second surface 22 which are located opposite from each other in the thickness direction D3 defined for the substrate 2. The semiconductor portion 3 is provided on the first surface 21 of the substrate 2. The semiconductor portion 3 includes a heterojunction 35 defining a junction between a first compound semiconductor portion 31 and a second compound semiconductor portion 32 and intersecting with a first direction D1 defined along the first surface 21 of the substrate 2. The first electrode 4 and the second electrode 5 are arranged on a first end surface 301 of the semiconductor portion 3 and on a second end surface 302 of the semiconductor portion 3, respectively, in a second direction D2 defined along the first surface 21 of the substrate 2 and aligned with the direction in which the heterojunction 35 extends. The first electrode 4 and the second electrode 5 are electrically connected to the heterojunction 35.

This configuration allows the semiconductor device 1 to reduce its resistance between the first electrode 4 and the second electrode 5.

Also, in this semiconductor device 1, the substrate 2 is a nitride semiconductor substrate. The first surface 21 of the substrate 2 is a crystallographic plane extending along a c-axis. In the semiconductor device 1, each of the first compound semiconductor portion 31 and the second compound semiconductor portion 32 is a nitride semiconductor. This allows the semiconductor device 1 to increase its breakdown voltage and reduce its resistance.

In this semiconductor device 1, the greater the length of the first heterojunction 35 in the thickness direction D3 defined for the substrate 2 is, the easier it is for the semiconductor device 1 to reduce RonA (which is on-state resistance per unit area and of which the unit may be Ω·cm², for example). As used herein, RonA is the product of Ron (which is the on-state resistance and of which the unit is Ω) and the area of the field effect transistor section 10 (which is the chip area of the field effect transistor chip in a plan view and may be 1 cm × 1 cm = 1 cm², for example).

In addition, in this semiconductor device 1, the larger the number of the first heterojunctions 35 is, the easier it is for the semiconductor device 1 to reduce its resistance. Thus, increasing the number of the first heterojunctions 35 by shortening the distance between the first heterojunctions 35 that are adjacent to each other in the first direction D1 allows the semiconductor device 1 to reduce RonA. That is to say, this allows the semiconductor device 1 to reduce RonA while increasing its breakdown voltage.

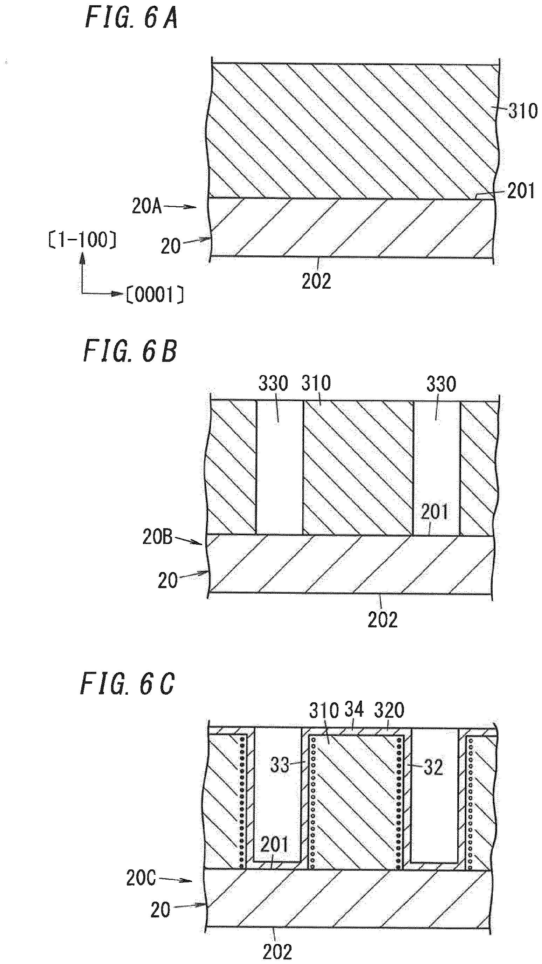

Next, an exemplary method for fabricating the semiconductor device 1 will be briefly described with reference to FIGS. 6A-8C.

According to this method for fabricating the semiconductor device 1, first, a wafer 20 (see FIG. 6A), which will be respective substrates 2 for a plurality of semiconductor devices 1, is provided. The wafer 20 may be a GaN wafer, for example. The wafer 20 has a first surface 201 and a second surface 202, which are located opposite from each other along the thickness thereof.

According to this method for fabricating the semiconductor device 1, after the wafer 20 has been provided, the following first through sixth process steps are performed sequentially.

In the first process step, the wafer 20 is subjected to pretreatment, loaded into an epitaxial growth system, and then a first compound semiconductor layer 310 (e.g., an undoped GaN layer in this example) to be patterned into first compound semiconductor portions 31 is stacked by epitaxial growth process (i.e., epitaxially grown) on the first surface 201 of the wafer 20 (see FIG. 6A). The first surface 201 of the wafer 20 is a surface corresponding to the first surface 21 of the substrate 2. If an MOVPE system is adopted as the epitaxial growth system, trimethylgallium (TMGa) is suitably used as a Ga source gas and NH₃ is suitably used as an N source gas. A carrier gas for the respective source gases is suitably an H₂ gas, an N₂ gas, or a mixture of an H₂ gas and an N₂ gas, for example. As for conditions for growing the first compound semiconductor layer 310, substrate temperature, V/III ratio, flow rates of the respective source gases, growth pressures, and other parameters may be set appropriately. The "substrate temperature" refers herein to the temperature of the wafer 20. When an MOVPE system is used as an epitaxial growth system, the "substrate temperature" may be replaced with the temperature of a susceptor supporting the wafer 20. For example, the substrate temperature may be replaced with the temperature of the susceptor measured with a thermocouple. The "V/III ratio" refers herein to the ratio of the molar flow rate [µmol/min] of a source gas of a Group V element to the molar flow rate [µmol/min] of a source gas of a Group III element. The "growth pressure" refers herein to the pressure in the reaction furnace in a state where the respective source gases and carrier gases are being supplied into the reaction furnace of the MOVPE system.

In the first process step, after the first compound semiconductor layer 310 has been grown epitaxially, a wafer 20A, including the wafer 20 and the first compound semiconductor layer 310, is unloaded from the epitaxial growth system.

In the second process step, the first compound semiconductor layer 310 is patterned by photolithography and etching techniques (see FIG. 6B). More specifically, in the second process step, a plurality of trenches 330 are formed from the surface of the first compound semiconductor layer 310 of the wafer 20A to obtain a wafer 20B including the wafer 20 and a patterned first compound semiconductor layer 310. The plurality of trenches 330 are arranged side by side in the first direction D1. The depth of the trenches 330 may be equal to, for example, the designed length of the first heterojunction 35 as measured in the thickness direction D3 defined for the substrate 2. In the wafer 20A, if the wafer 20 is a semi-insulating GaN wafer, the trenches 330 may be deep enough to reach the wafer 20. On the other hand, if the wafer 20 is an n-type GaN wafer, part of the first compound semiconductor layer 310 is suitably present between the bottom of the trenches 330 and the first surface 201 of the wafer 20. This allows, even when the wafer 20 is an n-type GaN wafer, the two-dimensional electron gas 37 and the two-dimensional hole gas 38 of the semiconductor portion 3 to be electrically insulated from the substrate 2 in the semiconductor device 1. An etching system for use in the process step of forming the plurality of trenches 330 may be an inductively coupled plasma (ICP) dry etching system, for example. As an etch gas, a Cl₂ gas, an SF₆ gas, or any other suitable gas may be used, for example.

In the third process step, the wafer 20B is loaded into an epitaxial growth system to stack, by epitaxial growth process (i.e., epitaxially grow), a second compound semiconductor layer 320 (e.g., an undoped AlGaN layer in this example) on the wafer 20B to cover the first compound semiconductor layer 310 (see FIG. 6C). In this manner, a wafer 20C, including the wafer 20, the patterned first compound semiconductor layer 310, and the second compound semiconductor layer 320, is obtained. The second compound semiconductor layer 320 includes a second compound semiconductor portion 32, a third compound semiconductor portion 33, and a fourth compound semiconductor portion 34. If an MOVPE system is adopted as the epitaxial growth system, trimethylaluminum (TMA1) is used as an A1 source gas, trimethylgallium (TMGa) is used as a Ga source gas, and NH₃ is used as an N source gas. A carrier gas for the respective source gases may be an H₂ gas, an N₂ gas, or a mixture of an H₂ gas and an N₂ gas, for example. In the third process step, after the second compound semiconductor layer 320 has been epitaxially grown, the wafer 20C, including the second compound semiconductor layer 320, is unloaded from the epitaxial growth system.

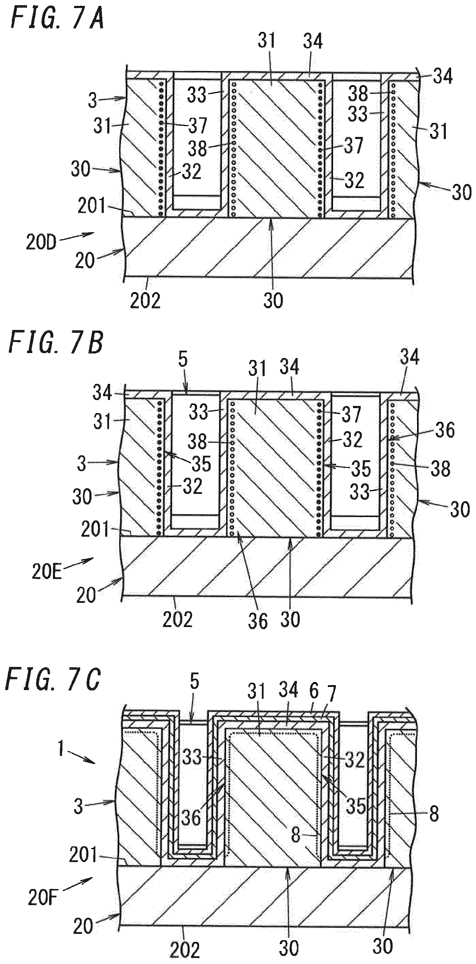

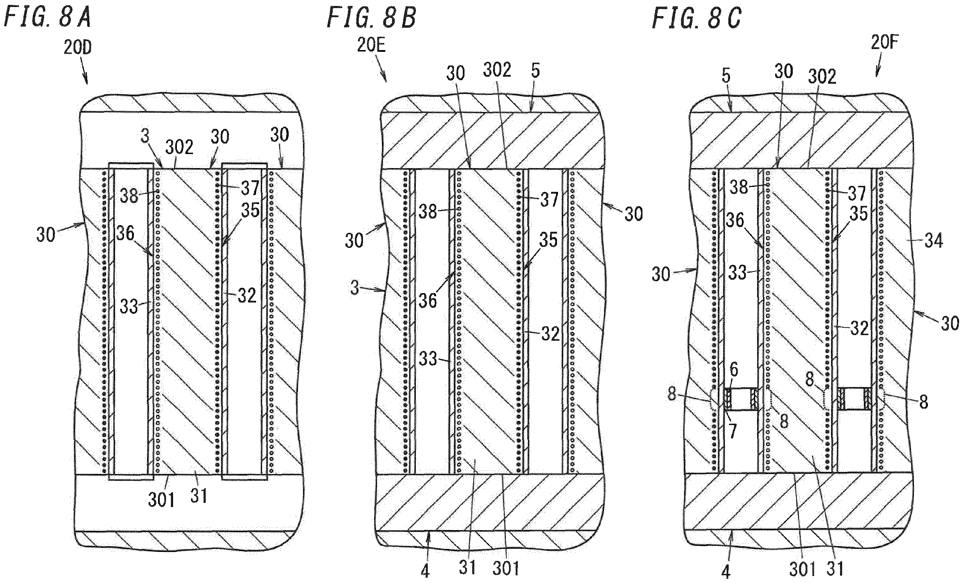

In the fourth process step, the second compound semiconductor layer 320 and the first compound semiconductor layer 310 are patterned by photolithography and etching techniques (see FIGS. 7A and 8A). As a result of this fourth process step, a semiconductor portion 3 with a first end surface 301 and a second end surface 302 is formed. In this manner, a wafer 20D, including the wafer 20 and the semiconductor portion 3, is obtained.

In the fifth process step, a first electrode 4 and a second electrode 5 are formed (see FIGS. 7B and 8B). More specifically, a metal layer, having a predetermined pattern as a prototype of the first electrode 4 and the second electrode 5, is formed by thin film deposition technique, for example, and then subjected to a sintering process which is a heat treatment to make an ohmic contact. As a result of this fifth process step, a first electrode 4 and a second electrode 5 electrically connected to the first heterojunctions 35 and the second heterojunctions 36 are formed. In this manner, a wafer 20E, including the wafer 20, the semiconductor portion 3, the first electrode 4, and the second electrode 5, is obtained.

In the sixth process step, a gate layer 7 and a gate electrode 6 are formed (see FIG. 7C and 8C). If the gate layer 7 is implemented as an NiO layer, the gate layer 7 may be formed by atomic layer deposition (ALD), for example. In this sixth process step, either a stack of a Pd film and an Au film or a stack of an Ni film and an Au film is formed to have a predetermined pattern as a prototype of the gate electrode 6. In this manner, a wafer 20F, including the wafer 20, the semiconductor portion 3, the first electrode 4, the second electrode 5, the gate layer 7, and the gate electrode 6, is obtained. At this time, a plurality of semiconductor devices 1 have been formed on the wafer 20F. That is to say, according to this method for fabricating the semiconductor device 1, such a wafer 20F with the plurality of semiconductor devices 1 is obtained by performing the first through sixth process steps.

Finally, according to this method for fabricating the semiconductor device 1, the wafer 20F is cut with a dicing saw, for example, to divide the single wafer 20F into a plurality of semiconductor devices 1. Optionally, according to this method for fabricating the semiconductor device 1, before the wafer 20F is diced, the wafer 20 may be polished from the second surface 202, opposite from the first surface 201, to make the thickness of the wafer 20 equal to a desired thickness of the substrate 2.

Note that the embodiment described above is only an exemplary one of various embodiments of the present invention and should not be construed as limiting. Rather, the embodiment described above may be readily modified in various manners, depending on a design choice or any other factor, without departing from a scope of the present invention.

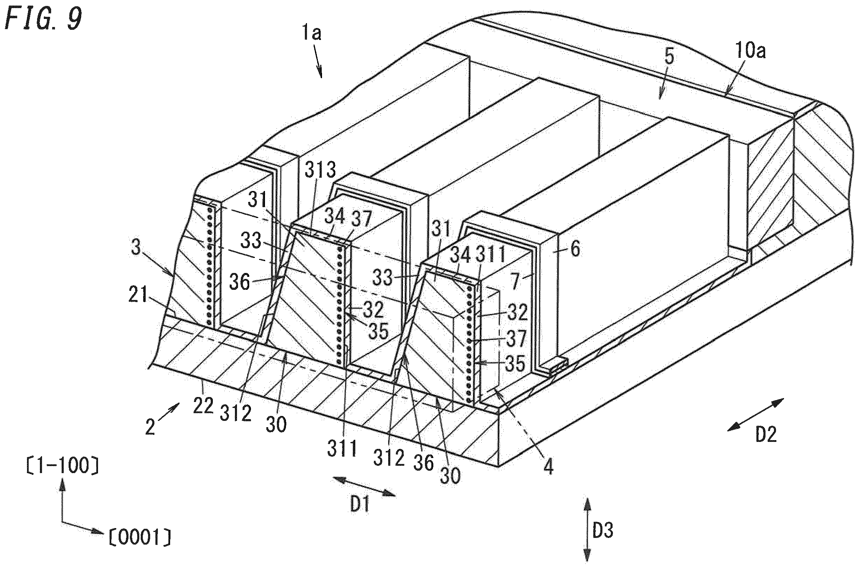

FIGS. 9A and 9B are cross-sectional views of a semiconductor device 1a as a first variation of the exemplary embodiment described above. In the following description, any constituent element of the semiconductor device 1a according to the first variation, having the same function as a counterpart of the semiconductor device 1 according to the embodiment described above, will be designated by the same reference numeral as that counterpart's, and a detailed description thereof will be omitted herein.

In the semiconductor device 1a according to the first variation, generation of the two-dimensional hole gas 38 (see FIG. 1) in the vicinity of the second heterojunction 36 may be reduced by setting the angle formed between a plane perpendicular to the first direction D1 and the second heterojunction 36 at a value greater than 10 degrees. This allows some constraint on the manufacturing condition such as the etching condition of the dry etching during the manufacturing process of the semiconductor device 1a (e.g., the etching condition of the dry etching in the second process step described above) to be relaxed. In this variation, in the semiconductor device 1a, the second surface 312 of the first compound semiconductor portion 31 is a tilted surface which forms a tilt angle larger than 10 degrees with respect to a plane perpendicular to the first direction D1.

A field effect transistor chip constituting the semiconductor device 1 according to the first variation includes a field effect transistor section 10a. In this variation, the field effect transistor section 10a, as well as the field effect transistor section 10 of the semiconductor device 1 according to the first embodiment, also includes the semiconductor portion 3, the source electrode 4, the drain electrode 5, the gate electrode 6, and the gate layer 7.

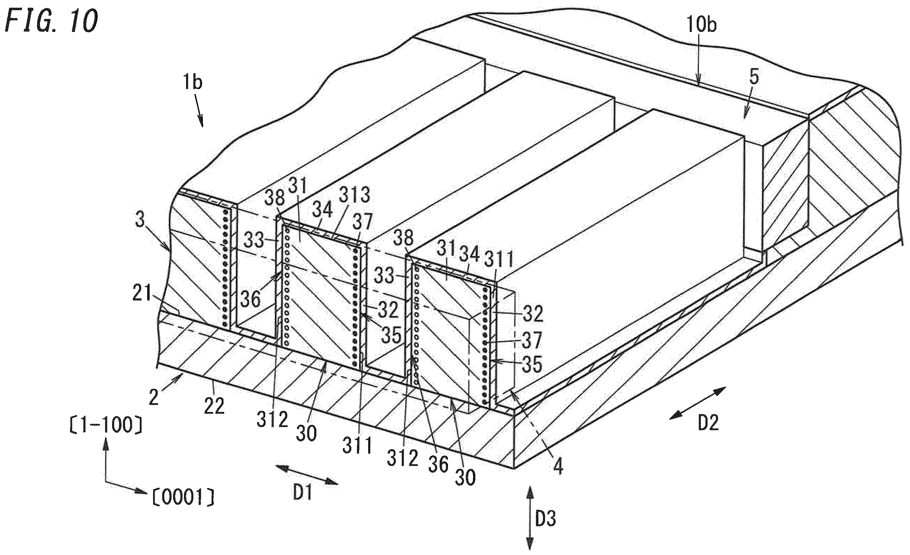

FIG. 10 is a cross-sectional view of a semiconductor device 1b according to a second variation of the exemplary embodiment. In the following description, any constituent element of the semiconductor device 1b according to the second variation, having the same function as a counterpart of the semiconductor device 1 according to the embodiment described above, will be designated by the same reference numeral as that counterpart's, and a detailed description thereof will be omitted herein.

The semiconductor device 1b according to the second variation is a diode chip. Thus, the semiconductor device 1b according to this second variation includes neither the gate electrode 6 nor the gate layer 7 of the semiconductor device 1 according to the embodiment described above. In the semiconductor device 1b according to this second variation, a plurality of double heterostructures 30 are arranged side by side in the first direction D1 as in the semiconductor device 1 according to the embodiment described above, and therefore, undoped AlGaN crystals and undoped GaN crystals are arranged alternately in the first direction D1. Thus, in the semiconductor device 1b according to this second variation, a plurality of two-dimensional electron gas layers and a plurality of two-dimensional hole gas layers are arranged alternately in the first direction D1 with respect to the semiconductor portion 3. Also, in the semiconductor device 1b according to this second variation, one of the first electrode 4 or the second electrode 5 constitutes an anode electrode while the other constitutes a cathode electrode. In the second variation, one of the first electrode 4 or the second electrode 5 which has the higher potential than the other when a voltage is applied between the first electrode 4 and the second electrode 5 constitutes an anode electrode, while the other electrode with the lower potential than the other constitutes a cathode electrode. As can also be seen from the foregoing description, in this semiconductor device 1b, the diode chip constituting the semiconductor device 1b includes a diode section 10b and the substrate 2. The diode section 10b is a multi-channel diode including the semiconductor portion 3, the first electrode 4, and the second electrode 5.

The first and second variations described above are not the only variations of the exemplary embodiment. The exemplary embodiment may also be readily modified in various other manners, depending on a design choice or any other factor, without departing from a scope of the present invention.

For example, the substrate 2 does not have to be a GaN substrate. Alternatively, the substrate 2 may also be an AlN substrate, for example.

Also, the plurality of double heterostructures 30 do not have to be arranged at regular intervals.

Furthermore, the gate layer 7 does not have to be an NiO layer but may also be a p-type AlGaN layer, for example. The p-type AlGaN layer has been doped with Mg during its growth and contains Mg. If a p-type AlGaN layer is adopted as the gate layer 7, the gate electrode 6 needs to make an ohmic contact with the gate layer 7.

Although the semiconductor device 1 according to the exemplary embodiment and the semiconductor device 1a according to the first variation each include the gate layer 7, the gate layer 7 is not an essential constituent element. If no gate layer 7 is provided, then the gate electrode 6 may be arranged to be in direct contact with the second compound semiconductor portion 32 in the first direction D1. When no gate layer 7 is provided, the semiconductor device 1 according to the exemplary embodiment and the semiconductor device 1a according to the first variation may each be implemented as a normally on-mode field effect transistor.

Optionally, each of the semiconductor device 1 according to the exemplary embodiment and the semiconductor device 1a according to the first variation may further include a first pad electrode electrically connected to the first electrode 4, a second pad electrode electrically connected to the second electrode 5, and a third pad electrode electrically connected to the third electrode 6. The first pad electrode, second pad electrode, and third pad electrode are electrodes to be connected to an external device.

Optionally, in the semiconductor device 1 according to the exemplary embodiment, the field effect transistor section 10 and the diode section 10b according to the second variation may be integrated together in a single chip. That is to say, the semiconductor device 1 may be implemented as a chip in which the field effect transistor section 10 and the diode section 10b are integrated together on the first surface 21 of the same substrate 2.

Optionally, the semiconductor device 1 according to the exemplary embodiment and the semiconductor device 1a according to the first variation may each include two field effect transistor sections 10. These two field effect transistor sections 10 may be connected together in anti-series by electrically connecting the respective source electrodes 4 of the two field effect transistor sections 10 together.

Furthermore, in the semiconductor portion 3, the heterojunction 35 between the first compound semiconductor portion 31 and the second compound semiconductor portion 32 only needs to give off the two-dimensional electron gas 37, and the first compound semiconductor portion 31, the second compound semiconductor portion 32, the third compound semiconductor portion 33, and the fourth compound semiconductor portion 34 do not have to be made of a nitride semiconductor but may also be made of any other Group III-V compound semiconductor. For example, in the semiconductor device 1, the first compound semiconductor portion 31 may be made of undoped GaAs crystals, and the second compound semiconductor portion 32, the third compound semiconductor portion 33, and the fourth compound semiconductor portion 34 may be made of Si-doped AlGaAs crystals. In that case, the substrate 2 is suitably a semi-insulating GaAs substrate, for example.

### (Resume)

The following aspects are disclosed from the exemplary embodiment and its variations described above.

A semiconductor device (1, 1a, 1b) according to a first aspect includes a substrate (2), a semiconductor portion (3), a first electrode (4), and a second electrode (5). The substrate (2) has a first surface (21) and a second surface (22) which are located opposite from each other in a thickness direction (D3) defined for the substrate (2). The semiconductor portion (3) is provided on the first surface (21) of the substrate (2). The semiconductor portion (3) includes a heterojunction (35) defining a junction between a first compound semiconductor portion (31) and a second compound semiconductor portion (32) and intersecting with a first direction (D1) defined along the first surface (21) of the substrate (2). The first electrode (4) and the second electrode (5) are arranged on a first end surface (301) of the semiconductor portion (3) and on a second end surface (302) of the semiconductor portion (3), respectively, in a second direction (D2) defined along the first surface (21) of the substrate (2) and aligned with a direction in which the heterojunction (35) extends. The first electrode (4) and the second electrode (5) are electrically connected to the heterojunction (35).

This configuration allows the semiconductor device (1, 1a, 1b) to reduce its resistance and cut down the loss.

In a semiconductor device (1, 1a, 1b) according to a second aspect, which may be implemented in conjunction with the first aspect, the substrate (2) is a nitride semiconductor substrate (2). The first surface (21) of the substrate (2) is a crystallographic plane extending along a c-axis. The first direction D1 is defined along the c-axis of the substrate (2). Each of the first compound semiconductor portion (31) and the second compound semiconductor portion (32) is a nitride semiconductor. This allows the semiconductor device (1, 1a, 1b) to increase its breakdown voltage and reduce its resistance.

In a semiconductor device (1, 1a, 1b) according to a third aspect, which may be implemented in conjunction with the first or second aspect, the semiconductor portion (3) suitably includes a plurality of the heterojunctions (35). This allows the semiconductor device (1, 1a, 1b) to increase its breakdown voltage and reduce its resistance.

In a semiconductor device (1, 1a, 1b) according to a fourth aspect, which may be implemented in conjunction with the third aspect, the plurality of the heterojunctions (35) extend parallel to each other. This allows the semiconductor device (1, 1a, 1b) to reduce its resistance.

In a semiconductor device (1, 1a) according to a fifth aspect, which may be implemented in conjunction with any one of the first to fourth aspects, in the semiconductor portion (3), the second compound semiconductor portion (32) has greater bandgap energy than the first compound semiconductor portion (31). The semiconductor device (1, 1a) further includes a gate electrode (6). The gate electrode (6) intersects with the first direction (D1) between the first electrode (4) and the second electrode (5). The gate electrode (6) faces the heterojunction (35) with at least the second compound semiconductor portion (32) interposed between the gate electrode (6) and the heterojunction (35). This allows the semiconductor device (1, 1a) to reduce its on-state resistance.

A semiconductor device (1, 1a) according to a sixth aspect, which may be implemented in conjunction with the fifth aspect, further includes a gate layer (7). The gate layer (7) is interposed in the first direction (D1) between the gate electrode (6) and the second compound semiconductor portion (32). The gate layer (7) forms a depletion layer (8) in the second compound semiconductor portion (32) and the first compound semiconductor portion (31). This allows the semiconductor device (1, 1a) to operate as a normally off-mode field effect transistor.

In a semiconductor device (1, 1a, 1b) according to a seventh aspect, which may be implemented in conjunction with the first aspect, the semiconductor portion (3) further includes a third compound semiconductor portion (33). The third compound semiconductor portion (33) is arranged, in the first direction (D1), opposite from the second compound semiconductor portion (32) with respect to the first compound semiconductor portion (31). In the semiconductor portion (3), bandgap energy of the second compound semiconductor portion (32) and bandgap energy of the third compound semiconductor portion (33) are each greater than bandgap energy of the first compound semiconductor portion (31). In this semiconductor device (1, 1a, 1b), the substrate (2) is a nitride semiconductor substrate, and the first surface (21) of the substrate (2) is a crystallographic plane extending along a c-axis. In the semiconductor device (1, 1a, 1b), each of the first compound semiconductor portion (31), the second compound semiconductor portion (32), and the third compound semiconductor portion (33) is a nitride semiconductor. The semiconductor portion (3) has a plurality of double heterostructures (30) arranged to be spaced apart from each other in the first direction (D1). In each of the plurality of double heterostructures (30), the third compound semiconductor portion (33), the first compound semiconductor portion (31), and the second compound semiconductor portion (32) are arranged in this order in the first direction (D1). Each of the plurality of double heterostructures (30) has a first heterojunction (35) defining the heterojunction (35) between the first compound semiconductor portion (31) and the second compound semiconductor portion (32) and a second heterojunction (36) defining a heterojunction (36) between the first compound semiconductor portion (31) and the third compound semiconductor portion (33). In the semiconductor device (1, 1a, 1b), one of the first electrode (4) or the second electrode (5) constitutes an anode electrode, and the other constitutes a cathode electrode. This allows the semiconductor device (1, 1a, 1b) to reduce its resistance while increasing its breakdown voltage.

### Reference Signs List

- 1, 1a, 1b: Semiconductor Device
- 2: Substrate
- 21: First Surface
- 22: Second Surface
- 3: Semiconductor Portion
- 30: Double Heterostructure
- 31: First Compound Semiconductor Portion
- 32: Second Compound Semiconductor Portion
- 33: Third Compound Semiconductor Portion
- 35: Heterojunction (First Heterojunction)
- 36: Heterojunction (Second Heterojunction)
- 301: First End Surface
- 302: Second End Surface
- 4: First Electrode
- 5: Second Electrode
- 6: Third Electrode
- 7: Gate Layer
- 8: Depletion Layer
- D1: First Direction
- D2: Second Direction
- D3: Thickness Direction

## Claims

1. A semiconductor device comprising:
a substrate having a first surface and a second surface that are located opposite from each other in a thickness direction defined for the substrate;
a semiconductor portion provided on the first surface of the substrate and including a heterojunction defining a junction between a first compound semiconductor portion and a second compound semiconductor portion, the heterojunction intersecting with a first direction defined along the first surface of the substrate; and
a first electrode and a second electrode that are arranged on a first end surface of the semiconductor portion and on a second end surface of the semiconductor portion, respectively, in a second direction defined along the first surface of the substrate and aligned with a direction in which the heterojunction extends, the first electrode and the second electrode being electrically connected to the heterojunction.

2. The semiconductor device of claim 1, wherein
the substrate is a nitride semiconductor substrate,
the first surface of the substrate is a crystallographic plane extending along a c-axis,
the first direction is defined along the c-axis, and
each of the first compound semiconductor portion and the second compound semiconductor portion is a nitride semiconductor.

3. The semiconductor device of claim 1 or 2, wherein
the semiconductor portion includes a plurality of the heterojunctions.

4. The semiconductor device of claim 3, wherein
the plurality of the heterojunctions extend parallel to each other.

5. The semiconductor device of any one of claims 1 to 4, wherein
in the semiconductor portion, the second compound semiconductor portion has greater bandgap energy than the first compound semiconductor portion, and
the semiconductor device further includes a gate electrode that intersects with the first direction between the first electrode and the second electrode and that faces the heterojunction with at least the second compound semiconductor portion interposed between the gate electrode and the heterojunction.

6. The semiconductor device of claim 5, further comprising a gate layer interposed in the first direction between the gate electrode and the second compound semiconductor portion and forming a depletion layer in the second compound semiconductor portion and the first compound semiconductor portion.

7. The semiconductor device of claim 1, wherein
the semiconductor portion further includes a third compound semiconductor portion arranged, in the first direction, opposite from the second compound semiconductor portion with respect to the first compound semiconductor portion,
in the semiconductor portion, bandgap energy of the second compound semiconductor portion and bandgap energy of the third compound semiconductor portion are each greater than bandgap energy of the first compound semiconductor portion,
the substrate is a nitride semiconductor substrate,
the first surface of the substrate is a crystallographic plane extending along a c-axis,
each of the first compound semiconductor portion, the second compound semiconductor portion, and the third compound semiconductor portion is a nitride semiconductor,
the semiconductor portion has a plurality of double heterostructures arranged to be spaced apart from each other in the first direction,
in each of the plurality of double heterostructures, the third compound semiconductor portion, the first compound semiconductor portion, and the second compound semiconductor portion are arranged in this order in the first direction, each of the plurality of double heterostructures having a first heterojunction defining the heterojunction between the first compound semiconductor portion and the second compound semiconductor portion and a second heterojunction defining a heterojunction between the first compound semiconductor portion and the third compound semiconductor portion, and
one of the first electrode or the second electrode constitutes an anode electrode, and the other constitutes a cathode electrode.
